# EUROPÄISCHE PATENTSCHRIFT

(11) **EP 1 470 745 B1**
(45) Veröffentlichungstag und Bekanntmachung des Hinweises auf die Patenterteilung: **05.07.2006**
(21) Anmeldenummer: 03702575.6
(22) Anmeldetag: 31.01.2003
(51) Int. Cl.: H05K 5/02, H05K 1/02

(54) **GEHÄUSE FÜR GERÄTE DER UNTERHALTUNGSELEKTRONIK**
HOUSING FOR ELECTRONIC HOME ENTERTAINMENT DEVICES
BOITIER POUR APPAREILS DE L'ELECTRONIQUE DE DIVERTISSEMENT

(30) Priorität: 02.02.2002 DE 10204257
(43) Veröffentlichungstag der Anmeldung: 27.10.2004
(73) Patentinhaber: Grundig Multimedia B.V., 1083HJ Amsterdam (NL)
(72) Erfinder: FRIEBE, Markus, 90419 Nürnberg (DE); SPINDLER, Johannes, 90482 Nürnberg (DE)
(74) Vertreter: Pröll, Jürgen
(86) Internationale Anmeldenummer: PCT/EP2003/000957
(87) Internationale Veröffentlichungsnummer: WO 2003/067947

(56) Entgegenhaltungen:
- EP-A- 0 526 821
- EP-A- 1 085 787
- WO-A-00/29208
- DE-A- 19 649 116
- US-A- 2 589 448
- PATENT ABSTRACTS OF JAPAN vol. 003, no. 060 (E-112), 23. Mai 1979 (1979-05-23) & JP 54 038791 A (SEIKO INSTR & ELECTRONICS LTD), 23. März 1979 (1979-03-23)

## Beschreibung

Die vorliegende Erfindung betrifft ein Gehäuse für ein Gerät der Unterhaltungselektronik.

Es sind Gehäuse für Geräte der Unterhaltungselektronik bekannt geworden, die beispielsweise aus transparentem Material gefertigt sind. Weiterhin sind Gehäuse für Geräte der Unterhaltungselektronik bekannt geworden, die mehrere Gehäuseteile aufweisen, z. B. ein erstes Gehäuseteil, welches das eigentliche Gerät der Unterhaltungselektronik aufweist, und eine zweites Gehäuseteil, das z. B. als Unterbau dazu verwendet wird, das erste Gehäuseteil in eine für den Betrieb erforderliche Position zu bringen.

Die bekannten Gehäuse für Geräte der Unterhaltungselektronik weisen jedoch den Nachteil auf, dass der Anschluss von z. B. elektrischen Versorgungsleitungen, Antenne, Lautsprechern usw. umständlich ist. Zudem kann durch die für den Anschluss verwendeten Leitungen das gesamte Erscheinungsbild des Geräts der Unterhaltungselektronik gestört werden. Ein weiteres Problem stellen mehrteilige Gehäuse oder Gehäuse mit Unterteil dar, bei denen die Anschlüsse im oberen Teil des Gehäuses vo2unehmen sind, da die in diesem Fall umherhängenden Anschlussleitungen ein beträchtliches Unfallrisiko darstellen.

Aus US-A-2,589,448 ist eine Lampe bekannt, welche transparente Lampensockel aufweisen, welche mit einem Elektrolyt gefüllt sind. Ober das Elektrolyt erfolgt eine Kontaktierung der in einer Fassung eingeschraubten Glühbime. Das Elektrolyt ist derartig gewählt, dass es "transluzent" ist.

Aus WO00/29208 ist eine heizbare Frontscheibe offenbart. In diese Frontscheibe sind transparente Substrate eingebracht, über welche mit elektrischem Strom versorgt die Scheibe beheizbar ist

Aus EP-A1-0526821 ist ein elektronisches Steuergerät offenbart, welches aus einem Plastikgehäuse besteht, an welchem Leiter aufgebracht sind.

Es ist daher Aufgabe der vorliegenden Erfindung, ein Gehäuse für ein Gerät der Unterhaltungselektronik anzugeben, bei welchem benötigte Anschlussleitungen ohne Probleme an das Gehäuse bzw. das Gerät der Unterhaltungselektronik angeschlossen werden können.

Bei der vorliegenden Erfindung wird diese Aufgabe durch die Merkmale des Anspruchs 1 gelöst.

Es wird dabei davon ausgegangen, daß ein transparentes und/oder opakes Gehäuse für ein Gerät der Unterhaltungselektronik elektrisch leitende Bestandteile für den Anschluß des Geräts der Unterhaltungselektronik aufweist, wobei die elektrisch leitenden Bestandteile nicht als solche wahrnehmbar sind.

Der Vorteil der Erfindung ist darin zu sehen, daß die für den Anschluß des Geräts der Unterhaltungselektronik benötigten Bestandteile im Gehäuse enthalten sind, so daß das Gerät der Unterhaltungselektronik einfach anschließbar ist. Zusätzlich werden die für den Anschluß benötigten Bestandteile nicht als störend empfunden, da sie nicht sichtbar sind, bzw. so in das Gehäuse integriert sind, daß sie nicht wahrgenommen werden können. Durch Vermeidung umherhängender Anschlußleitungen entfällt zudem ein eventuelles Unfallrisiko.

Weitere Vorteile der vorliegenden Erfindung ergeben sich aus den abhängigen Ansprüchen sowie der nachfolgenden Beschreibung von Ausführungsformen von erfindungsgemäßen Gehäusen für Geräte der Unterhaltungselektronik anhand von Figuren.

Es zeigt:
- Figur 1: ein Gehäuse für ein Gerät der Unterhaltungselektronik,
- Figur 2: eine erste erfindungsgemäße Ausführungsform eines Teils des Gehäuses nach Figur 1,
- Figur 3: eine zweite erfindungsgemäße Ausführungsform eines Teils des Gehäuses nach Figur 1,
- Figur 4: eine dritte erfindungsgemäße Ausführungsform eines Teils des Gehäuses nach Figur 1, und
- Figur 5: eine vierte erfindungsgemäße Ausführungsform eines Teils des Gehäuses nach Figur 1.

Zur Erleichterung des Verständnisses der vorliegenden Erfindung sind in den Figuren nur die Bestandteile dargestellt, die im Zusammenhang mit der Erfindung von Bedeutung sind. Gleichartige Bestandteile in unterschiedlichen Figuren weisen die selben Bezugszeichen auf.

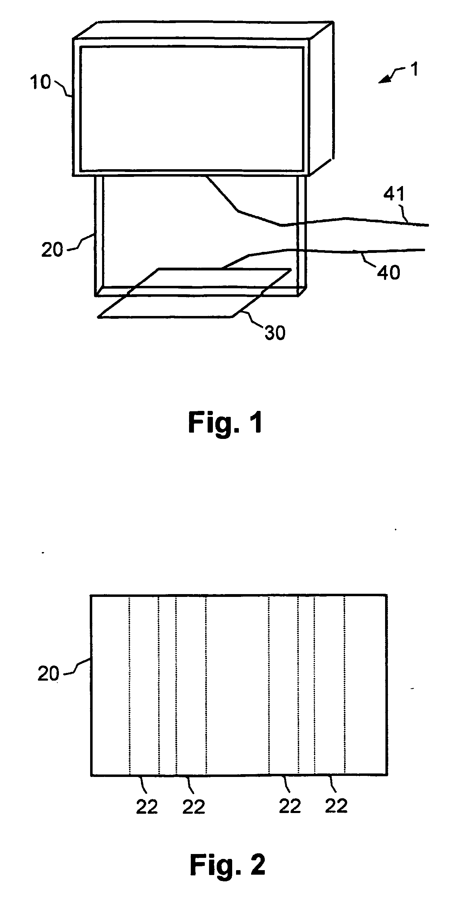

In Figur 1 ist ein Gehäuse 10, 20, 30 für ein Gerät der Unterhaltungselektronik 1 dargestellt. Das Gerät der Unterhaltungselektronik 1 ist im dargestellten Beispiel ein Fernsehgerät, welches aus einem ersten Gehäuseteil 10, mit den eigentlichen Bestandteilen des Fernsehgeräts, wie Bildschirm, Elektronik usw., einem zweiten Gehäuseteil 20, z. B. einem Unterbau, sowie einem Fuß 30 besteht. Andere Gehäuselösungen und Gehäuselösungen für andere Geräte der Unterhaltungselektronik sind möglich. Das Gehäuse 10, 20, 30 oder Teile davon, insbesondere jedoch das zweite Gehäuseteil 20 ist aus einem transparentem und/oder opaken Material hergestellt. Dazu eignet sich insbesondere Glas, Milchglas, Rauchglas, Acrylglas usw.

Die mit dem Bezugszeichen 41 gekennzeichnete Anschlußleitung stellt den aus dem Stand der Technik bekannten Zustand dar, bei dem die Anschlußleitung 41 mit dem ersten Gehäuseteil 10 verbunden ist - mit den bekannten und eingangs beschriebenen Nachteilen, wie z. B. einer erhöhten Unfallgefahr.

Die mit dem Bezugszeichen 40 gekennzeichnete Anschlußleitung stellt den erfindungsgemäßen Zustand dar, bei dem die Anschlußleitung 40 beispielsweise mit dem Fuß 30 verbunden ist. Ebenso ist es möglich, daß die Anschlußleitung direkt mit dem zweiten Gehäuseteil 20 verbunden ist, dies geschieht vorteilhaft im Bereich des Boden, d. h. auf der Höhe des Fußes 30. Statt der im Beispiel dargestellten einzigen Anschlußleitung 40 können weitere Anschlußleitungen, z. B. für die elektrische Versorgung, Antenne, Lautsprecher usw., mit dem Fuß 30 und/oder dem zweiten Gehäuseteil 20 verbunden sein.

In Figur 2 ist eine erste erfindungsgemäße Ausführungsform des zweiten Gehäuseteils 20 nach Figur 1 dargestellt. Das zweite Gehäuseteil 20 weist elektrisch leitende Bestandteile 22 auf, die einerseits mit der oder den Anschlußleitungen 40 verbunden sind, z. B. über den Fuß 30 oder direkt, und andererseits mit dem Gerät der Unterhaltungselektronik 1 im ersten Gehäuseteil 10.

Die elektrisch leitenden Bestandteile 22 sind transparent und somit nicht wahrnehmbar. Besonders geeignet für die elektrisch leitenden Bestandteile 22 ist Indium-Zinn-Oxid, das z. B. in leiterbahnartigen Strukturen aufgebracht wird. Vorteilhaft werden die elektrisch leitenden Bestandteile 22 auf einer Oberfläche des zweiten Gehäuseteils 20 aufgebracht, die im Inneren des zweiten Gehäuseteils 20 liegt, wozu z. B. zwei Glasscheiben miteinander verbunden werden können. Dadurch werden Gefahren vermieden, die sich bei der Berührung der elektrisch leitenden Bestandteile 22 ergeben können, wenn diese z. B. im Falle der Spannungsversorgung auf einem höheren elektrischen Potential liegen.

Um den Erfordernissen des jeweils zu bewerkstelligenden Anschlusses gerecht zu werden, können die elektrisch leitenden Bestandteile 22 hinsichtlich der Breite der leiterbahnartigen Strukturen und ihrer Abstände zueinander angepaßt werden. Beispielsweise werden für die elektrische Versorgung breite elektrische Bestandteile 22 mit einem größeren Abstand voneinander verwendet, um einerseits höhere Ströme leiten zu können und andererseits einen Spannungsüberschlag zu vermeiden.

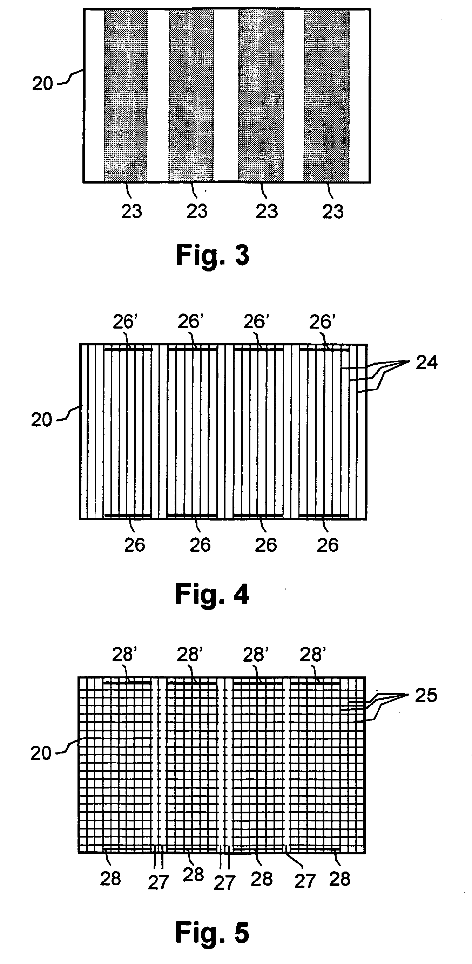

In Figur 3 ist eine zweite erfindungsgemäße Ausführungsform des zweiten Gehäuseteils 20 nach Figur 1 dargestellt. Das zweite Gehäuseteil 20 weist elektrisch leitende Bestandteile 23 auf, die einerseits mit der oder den Anschlußleitungen 40 verbunden sind, z. B. über den Fuß 30 oder direkt, und andererseits mit dem Gerät der Unterhaltungselektronik 1 im ersten Gehäuseteil 10.

Die elektrisch leitenden Bestandteile 23 sind teiltransparent und bilden einen Bestandteil der Gestaltung zumindest des zweiten Gehäuseteils 20. Somit werden die elektrischen Bestandteile 23 nicht wahrgenommen, da sie dem Erscheinungsbild des Gehäuses angepaßt sind. Besonders geeignet für die elektrisch leitenden Bestandteile 23 sind Metalle, z. B. Silber, Gold, Kupfer, Aluminium, die als sehr dünne Schichten in leiterbahnartigen Strukturen aufgebracht werden. Vorteilhaft werden die elektrisch leitenden Bestandteile 23 auf einer Oberfläche des zweiten Gehäuseteils 20 aufgebracht, z. B. durch Aufdampfen, die im Inneren des zweiten Gehäuseteils 20 liegt, wozu z. B. zwei Glasscheiben miteinander verbunden werden können. Dadurch werden Gefahren vermieden, die sich bei der Berührung der elektrisch leitenden Bestandteile 23 ergeben können, wenn diese z. B. im Falle der Spannungsversorgung auf einem höheren elektrischen Potential liegen.

Um den Erfordernissen des jeweils zu bewerkstelligenden Anschlusses gerecht zu werden, können die elektrisch leitenden Bestandteile 23 hinsichtlich der Breite der leiterbahnartigen Strukturen und ihrer Abstände zueinander angepaßt werden. Beispielsweise werden für die elektrische Versorgung breite elektrische Bestandteile 23 mit einem größeren Abstand voneinander verwendet, um einerseits höhere Ströme leiten zu können und andererseits einen Spannungsüberschlag zu vermeiden. Um ein gleichmäßiges Erscheinungsbild zu wahren wird es jedoch bevorzugt, die elektrisch leitenden Bestandteile 23 als Leiterbahnen mit gleicher Breite und gleichem Abstand auszuführen. Zu einer sicheren elektrischen Isolierung reichen dabei in der Regel Abstände zwischen den Leiterbahnen aus, die vom menschlichen Auge nicht mehr aufgelöst werden können, wodurch sich ein besonders homogenes Erscheinungsbild ergibt.

Machen es die elektrischen Erfordernisse notwendig, können mehrere der Leiterbahnen 23 zu einer Leitung zusammengefaßt werden. In diesem Fall werden die entsprechenden Leiterbahnen am oberen und unteren Ende elektrisch leitend miteinander verbunden, z. B. im Bereich des ersten Gehäuseteils 10 und des Fußes 30, so daß die Verbindungen nicht sichtbar sind. Ebenso ist es möglich, falls der Abstand zwischen den Leiterbahnen 23 zur Isolierung nicht ausreicht, eine oder mehrere der Leiterbahnen 23 nicht zu Anschlußzwecken zu verwenden.

In Figur 4 ist eine dritte erfindungsgemäße Ausführungsform des zweiten Gehäuseteils 20 nach Figur 1 dargestellt. Das zweite Gehäuseteil 20 weist elektrisch leitende Bestandteile 24 auf, die einerseits über Kontakte 26 mit der oder den Anschlußleitungen 40 verbunden sind, z. B. über den Fuß 30 oder direkt, und andererseits über Kontakte 26' mit dem Gerät der Unterhaltungselektronik 1 im ersten Gehäuseteil 10.

Die elektrisch leitenden Bestandteile 24 sind sichtbar und bilden einen Bestandteil der Gestaltung zumindest des zweiten Gehäuseteils 20. Somit werden die elektrisch leitenden Bestandteile 24 nicht wahrgenommen, da sie Bestandteil des Erscheinungsbilds des Gehäuses sind. Besonders geeignet für die elektrisch leitenden Bestandteile 24 sind Metalle, z. B. Silber, Gold, Kupfer, Aluminium, die in leiterbahartigen Strukturen aufgebracht sind. Vorteilhaft werden die elektrisch leitenden Bestandteile 24 auf einer Oberfläche des zweiten Gehäuseteils 20 aufgebracht, z. B. durch Ätzen der metallisierten Oberfläche, oder durch Drucken bzw. Aufkleben elektrisch leitender Bahnen, die im Inneren des zweiten Gehäuseteils 20 liegt, wozu z. B. zwei Glasscheiben miteinander verbunden werden können. Dadurch werden Gefahren vermieden, die sich bei der Berührung der elektrisch leitenden Bestandteile 24 ergeben können, wenn diese z. B. im Falle der Spannungsversorgung auf einem höheren elektrischen Potential liegen. Ebenso können die elektrisch leitenden Bestandteile 24 durch Einbringen elektrischer Leiter, z. B. metallischer Fäden, in das Material des Gehäuses 20 erzeugt werden. Bevorzugt ist es vorgesehen, die elektrisch leitenden Bestandteile 24 schmal auszugestalten.

Um den Erfordernissen des jeweils zu bewerkstelligenden Anschlusses gerecht zu werden, werden die elektrisch leitenden Bestandteile 24 mit den bereits erwähnten Kontakten 26, 26' am oberen und unteren Ende elektrisch leitend miteinander verbunden. Dies kann z. B. im Bereich des ersten Gehäuseteils 10 und des Fußes 30 erfolgen, so daß die Verbindungen nicht sichtbar sind. Um die Isolierung der elektrisch leitenden Bestandteile 24 voneinander zu gewährleisten können ausreichende Abstände zwischen den elektrisch leitenden Bestandteilen 24 gewählt werden, oder einen oder mehrere der elektrisch leitenden Bestandteile 24 nicht zu Anschlußzwecken zu verwenden.

In Figur 5 ist eine vierte erfindungsgemäße Ausführungsform des zweiten Gehäuseteils 20 nach Figur 1 dargestellt. Das zweite Gehäuseteil 20 weist elektrisch leitende Bestandteile 25 auf, die einerseits über Kontakte 28 mit der oder den Anschlußleitungen 40 verbunden sind, z. B. über den Fuß 30 oder direkt, und andererseits über Kontakte 28' mit dem Gerät der Unterhaltungselektronik 1 im ersten Gehäuseteil 10.

Die Ausführungsform nach Figur 5 stellt eine Variante der Ausführungsform nach Figur 4 dar, wobei die elektrisch leitenden Bestandteile 25 nach Figur 5 zur Erhöhung der elektrischen Leitfähigkeit als Gitterstruktur ausgestaltet sind. Ansonsten entspricht die Realisierung der Ausführungsform nach Figur 5 der Ausführungsform nach Figur 4.

Zur Erzielung der Erfordernisse des jeweils zu bewerkstelligenden Anschlusses werden entsprechende Gitterflächen mit Kontakten 28, 28' am oberen und unteren Ende elektrisch leitend miteinander verbunden. Dies kann z. B. im Bereich des ersten Gehäuseteils 10 und des Fußes 30 erfolgen, so daß die Verbindungen nicht sichtbar sind. Um die Isolierung der elektrischen Bestandteile 25 voneinander zu gewährleisten können ausreichende Abstände zwischen den elektrischen Bestandteilen 25 durch ein- oder mehrfache Unterbrechung 27 der Gitterstruktur erreicht werden.

Falls ein mehrteiliges, trennbares Gehäuse verwendet wird, z. B. aus erstem Gehäuseteil 10 und zweitem Gehäuseteil 20, wobei die Gehäuseteile 10 und 20 lösbar verbunden sind, kann es vorgesehen sein, daß zwischen den Gehäuseteilen 10 und 20 entsprechende Verbindungen vorgesehen werden, z. B. Steckkontakte, lösbare Verbindungsleitungen usw. Mittels dieser Verbindungen werden dann die elektrisch leitenden Bestandteile 22, 23, 24, 25 des zweiten Gehäuseteils 20 mit dem Gerät der Unterhaltungselektronik 1 im ersten Gehäuseteil 10 verbunden.

In den beschriebenen Beispielen verlaufen die elektrisch leitenden Bestandteile 22 bis 25 parallel zu zwei der Außenkanten des Gehäuses 20, es ist aber offensichtlich, daß die elektrisch leitenden Bestandteile 22 bis 25 auch schräg in Bezug auf die Außenkanten des Gehäuses 20 und/oder mit nicht geradem Verlauf angeordnet sein können. Es ist jedoch bevorzugt, daß die elektrisch leitenden Bestandteile 22 bis 25 zueinander parallel verlaufen.

## Patentansprüche

1. Gehäuse (10, 20, 30) für ein Gerät der Unterhaltungselektronik (1), welches aus transparentem und/oder opakem Material besteht und elektrisch leitende Bestandteile (22; 23; 24; 25) für den Anschluss (40) des Geräts der Unterhaltungselektronik (1) aufweist, wobei die elektrisch leitenden Bestandteile (22; 23; 24; 25) nicht als solche wahrnehmbar sind,
**dadurch gekennzeichnet,dass**
die elektrisch leitenden Bestandteile (22) transparent oder die leitenden Bestandteile (23) teiltransparent sind, das Gehäuse (10, 20, 30) als mehrteiliges, trennbares Gehäuse (10, 20, 30) ausgestaltet ist und elektrische Verbindungen vorgesehen sind, insbesondere Steckkontakte oder lösbare Verbindungsleitungen, zur Herstellung einer lösbaren elektrischen Verbindung zwischen den elektrisch leitenden Bestandteilen (22; 23; 24; 25) und dem Gerät der Unterhaltungselektronik (1), wobei die elektrischen Verbindungen zwischen den elektrisch leitenden Bestandteilen (23) und dem Gerät der Unterhaltungselektronik (1) einfach lösbar sind und die elektrisch leitenden Bestandteilen (23) nicht nur im Gehäuse (10, 20, 30) integriert oder enthalten sind, sondern einen Bestandteil der Gestaltung des Gehäuses (10, 20, 30) des Gerätes der Unterhaltungselektronik (1) bilden und dem Erscheinungsbild des Gehäuses (10, 20, 30) des Gerätes der Unterhaltungselektronik (1) angepasst sind.

2. Gehäuse nach Anspruch 1,
**dadurch gekennzeichnet, dass**
die elektrisch leitenden Bestandteile (22) aus Indium-Zinn-Oxid bestehen.

3. Gehäuse nach Anspruch 1,
**dadurch gekennzeichnet, dass**
die elektrisch leitenden Bestandteile (23) aus einer dünnen Metallschicht bestehen und die dünne Metallschicht (23) aus Gold und/oder Silber und/oder Kupfer und/oder Aluminium besteht.

4. Gehäuse nach Anspruch 1,
**dadurch gekennzeichnet, dass**
die elektrisch leitenden Bestandteile (24; 25) Gestaltungselemente zumindest von Teilen des Gehäuses (10; 20; 30) sind und die elektrisch leitenden Bestandteile (24; 25) als Bahnen oder Fäden ausgebildet sind und die Bahnen oder Fäden (24; 25) aus Metall bestehen, insbesondere aus Gold und/oder Silber und/oder Kupfer und/oder Aluminium.

5. Gehäuse nach Anspruche 4,
**dadurch gekennzeichnet, dass**
die elektrisch leitenden Bestandteile (25) als Gitter angeordnet sind.

6. Gehäuse nach einem der Ansprüche 1 bis 5,
**dadurch gekennzeichnet, dass**
die elektrisch leitenden Bestandteile (22; 23; 24; 25) im Inneren des Gehäuses (10, 20, 30) liegen, und daß das Gehäuse (10, 20, 30) zumindest im Bereich der elektrisch leitenden Bestandteile (22; 23; 24; 25) als Isolator ausgebildet ist.

7. Gehäuse nach einem der Ansprüche 1 bis 6,
**dadurch gekennzeichnet, dass**
die elektrisch leitenden Bestandteile (22; 23; 24; 25) parallel zueinander verlaufen.

8. Gehäuse nach einem der Ansprüche 1 bis 7,
**dadurch gekennzeichnet,dass**
die elektrisch leitenden Bestandteile (22; 23; 24; 25) parallel zu Außenkanten des Gehäuses (10, 20, 30) verlaufen.

9. Gehäuse nach einem der Ansprüche 1 bis 8,
**dadurch gekennzeichnet, daß**
die elektrisch leitenden Bestandteile (22; 23; 24; 25) schräg zu Außenkanten des Gehäuses (10, 20, 30) verlaufen.

10. Gehäuse nach einem der Ansprüche 1 bis 9,
**dadurch gekennzeichnet, daß**
die elektrisch leitenden Bestandteile (22; 23; 24; 25) mittels Kontakten (26; 28) zusammenschaltbar sind und die Kontakten (26; 28) im Bereich des Gehäuses (10, 30) verlaufen, in denen sie nicht sichtbar sind.

## Claims

1. Housing (10, 20, 30) for an entertainment electronics appliance (1), which housing is composed of transparent and/or opaque material and comprises electrically conducting components (22; 23; 24; 25) for the connection (40) of the entertainment electronics appliance (1), wherein the electrically conducting components (22; 23; 24; 25) are not perceptible as such, **characterized in that** the electrically conducting components (22) are transparent or the conducting components (23) are partially transparent, the housing (10, 20, 30) is designed as a multipart, separable housing (10, 20, 30) and electrical connections are provided, in particular plug contacts or releasable connecting lines, for making a releasable electrical contact between the electrically conducting components (22; 23; 24; 25) and the entertainment electronics appliance (1), wherein the electrical connections between the electrically conducting components (23) and the entertainment electronics appliance (1) are easily releasable and the electrically conducting components (23) are not only integrated or contained in the housing (10, 20, 30), but form a component of the design of the housing (10, 20, 30) of the entertainment electronics appliance (1) and are matched to the appearance of the housing (10, 20, 30) of the entertainment electronics appliance (1).

2. Housing according to Claim 1, **characterized in that** the electrically conducting components (22) are composed of indium/tin oxide.

3. Housing according to Claim 1, **characterized in that** the electrically conducting components (23) are composed of a thin metal layer and the thin metal layer (23) is composed of gold and/or silver and/or copper and/or aluminium.

4. Housing according to Claim 1, **characterized in that** the electrically conducting components (24; 25) are design elements at least of parts of the housing (10, 20, 30) and the electrically conducting components (24; 25) are formed as webs or threads and the webs or threads (24; 25) are composed of metal, in particular of gold and/or silver and/or copper and/or aluminium.

5. Housing according to Claim 4, **characterized in that** the electrically conducting components (25) are disposed as a grid.

6. Housing according to any one of Claims 1 to 5, **characterized in that** the electrically conducting components (22; 23; 24; 25) are situated in the interior of the housing (10, 20, 30) and **in that** the housing (10, 20, 30) is formed at least in the region of the electrically conducting components (22; 23; 24; 25) as an insulator.

7. Housing according to any one of Claims 1 to 6, **characterized in that** the electrically conducting components (22; 23; 24; 25) extend parallel to one another.

8. Housing according to any one of Claims 1 to 7, **characterized in that** the electrically conducting components (22; 23; 24; 25) extend parallel to external edges of the housing (10, 20, 30).

9. Housing according to any one of Claims 1 to 8, **characterized in that** the electrically conducting components (22; 23; 24; 25) extend obliquely to external edges of the housing (10, 20, 30).

10. Housing according to any one of Claims 1 to 9, **characterized in that** the electrically conducting components (22; 23; 24; 25) can be connected together by means of contacts (26; 28) and the contacts (26; 28) extend in the region of the housing (10,30) in which they are not visible.

## Revendications

1. Boîtier (10, 20, 30) pour un appareil de l'électronique de divertissement (1), qui est réalisé en un matériau transparent et/ou opaque et comprend des composants électriquement conducteurs (22 ; 23 ; 24 ; 25) pour la connexion (40) de l'appareil de l'électronique de divertissement (1), dans lequel les composants électriquement conducteurs (22 ; 23 ; 24 ; 25) ne sont pas perceptibles en tant que tels,
**caractérisé en ce que**
les composants électriquement conducteurs (22) sont transparents ou les composants conducteurs (23) sont partiellement transparents, le boîtier (10, 20, 30) est réalisé sous la forme d'un boîtier séparable en plusieurs parties (10, 20, 30) et des liaisons électriques sont prévues, en particulier des contacts à fiches ou des lignes de connexion amovibles, en vue de l'établissement d'une liaison électrique amovible entre les composants électriquement conducteurs (22 ; 23 ; 24 ; 25) et l'appareil de l'électronique de divertissement (1), où les liaisons électriques entre les composants électriquement conducteurs (23) et l'appareil de l'électronique de divertissement (1) sont simplement amovibles et les composants électriquement conducteurs (23) ne sont pas intégrés ou contenus seulement dans le boîtier (10, 20, 30), mais forment un composant de la structure du boîtier (10, 20, 30) de l'appareil de l'électronique de divertissement (1) et sont adaptés à l'apparence du boîtier (10, 20, 30) de l'appareil d'électronique de divertissement (1).

2. Boîtier selon la revendication 1, **caractérisé en ce que** les composants électriquement conducteurs (22) sont composés d'oxyde indium-étain.

3. Boîtier selon la revendication 1, **caractérisé en ce que** les composants électriquement conducteurs (23) sont composés d'une fine couche métallique et la fine couche métallique (23) est composée d'or et/ou d'argent et/ou de cuivre et/ou d'aluminium.

4. Boîtier selon la revendication 1, **caractérisé en ce que** les composants électriquement conducteurs (24 ; 25) sont des éléments de structure au moins de parties du boîtier (10 ; 20 ; 30) et les composants électriquement conducteurs (24,25) sont réalisés sous forme de bandes ou de fils et les bandes ou les fils (24 ; 25) sont composés de métal, en particulier d'or et/ou d'argent et/ou de cuivre et/ou d'aluminium.

5. Boîtier selon la revendication 4, **caractérisé en ce que** les composants électriquement conducteurs (25) sont disposés sous forme de grille.

6. Boîtier selon l'une des revendications 1 à 5, **caractérisé en ce que** les composants électriquement conducteurs (22 ; 23 ; 24 ; 25) se trouvent à l'intérieur du boîtier (10, 20, 30), et **en ce que** le boîtier (10, 20, 30) est réalisé sous la forme d'un isolateur au moins dans la zone des composants électriquement conducteurs (22 ; 23 ; 24; 25).

7. Boîtier selon l'une des revendications 1 à 6, **caractérisé en ce que** les composants électriquement conducteurs (22 ; 23 ; 24 ; 25) s'étendent parallèlement les uns aux autres.

8. Boîtier selon l'une des revendications 1 à 7, **caractérisé en ce que** les composants électriquement conducteurs (22 ; 23 ; 24 ; 25) s'étendent parallèlement au bord extérieur du boîtier (10, 20, 30).

9. Boîtier selon l'une des revendications 1 à 8, **caractérisé en ce que** les composants électriquement conducteurs (22 ; 23 ; 24 ; 25) s'étendent obliquement par rapport au bord extérieur du boîtier (10, 20, 30).

10. Boîtier selon l'une des revendications 1 à 9, **caractérisé en ce que** les composants électriquement conducteurs (22 ; 23 ; 24 ; 25) peuvent être interconnectés au moyen de contacts (26 ; 28) et les contacts (26 ; 28) s'étendent dans la zone du boîtier (10, 30), dans laquelle ils ne sont pas visibles.
